(19) Europäisches Patentamt
European Patent Office
Office européen des brevets

(11) Publication number: **0 136 840 B1**

# (12) EUROPEAN PATENT SPECIFICATION

(45) Date of publication of patent specification: **25.03.92**

(51) Int. Cl.$^5$: **G02F 3/00**, H01S 3/103

(21) Application number: **84306040.1**

(22) Date of filing: **04.09.84**

## (54) Opto-electric logic element.

(30) Priority: **06.09.83 JP 163449/83**
**17.04.84 JP 76787/84**

(43) Date of publication of application:
**10.04.85 Bulletin 85/15**

(45) Publication of the grant of the patent:
**25.03.92 Bulletin 92/13**

(84) Designated Contracting States:
**DE FR GB NL**

(56) References cited:
**GB-A- 1 097 066**
**GB-A- 2 114 768**
**US-A- 3 654 497**

**IEEE SPECTRUM, vol. 18, June 181, pages 26-33, IEEE, New York, US; P.W. SMITH et al.: "Bistable optical devices promise subpicosecond switching"**

(73) Proprietor: **NEC CORPORATION**
**7-1, Shiba 5-chome Minato-ku**
**Tokyo 108-01(JP)**

(72) Inventor: **Suzuki, Syuji**
**c/o NEC Corporation 33-1, Shiba 5-chome**
**Minato-ku Tokyo(JP)**

(74) Representative: **Pears, David Ashley et al**
**REDDIE & GROSE 16 Theobalds Road**
**London WC1X 8PL(GB)**

EP 0 136 840 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to an opto-electric logic element comprising a semiconductor laser, means for supplying at least one light input signal to the laser, and a circuit for supplying an injection current to the laser.

Optical communication utilising optical fibers in a transmission path is expected to be used widely in the future partly because optical fibers have a wide frequency bandwidth and partly because the optical fibers are immune from induction noise.

In an optical communication system, information to be transmitted is converted into an optical signal from an electric signal, and the optical signal is transmitted through optical fibers and then converted back into an electric signal at a receiving apparatus. Thus the optical signal is utilised as a transmission medium that sends a signal from one point to another by taking advantage of the fact that the transmission loss of the optical fibers constituting the transmission path is very small, but the optical signal does not play a positive role in signal processing such as logical operation or the like.

US-A-3 654 497 describes an opto-electric logic element comprising a semiconductor laser with an enhanced concentration of saturable absorption trapping centres, referred to as the memory laser A, two input or read lasers B and C for supplying light input signals to the memory laser, and a circuit for supplying an injection current to the memory laser. This known logic element can carry out logic operations or storage of light input signals. The logic operations are made possible by suitably choosing the value of the injection current and the levels of the two light input signals. Thus if the current threshold of lasing for zero light input is $I_A$, and is $I_A$-$\Delta I$ for one light input B or C, then the element is operated with an injection current $I_1$ such that $(I_A-\Delta I) < I_1 < I_A$ for a logical OR operation. In other words, the memory laser lases if either read laser is ON, or more formally: $A = B + C$. Again, if the injection current is $I_2$ such that $(I_A-2\Delta I) < I_2 < (I_2-\Delta I)$, memory laser A lases if and only if both lasers B and C are ON, i.e. $A = B.C$, the logical AND operation. For a storage operation, the injection current supplied to the read lasers must be chosen also, and one of the read lasers must have its threshold lowered by trap saturation. In the storage operation, when the memory laser is ON, only one of the read lasers can lase, and when the memory laser is OFF, only the other read laser can lase. Thus the optical signal (ON or OFF) stored in the memory laser is read optically by the read lasers. There therefore remains a need for an opto-electric logic element by means of which a logical operation can be carried out between an optical signal and an electric signal, or by means of which storage of an optical signal can be accomplished under the control of an electric signal, and the results of the logical operation or storage can be obtained in the form of optical signals, since then the field of application of optical communication systems will be greatly widened.

According to the present invention therefore, an opto-electric logic element of the kind defined hereinbefore at the beginning is characterised in that the current supplying circuit has an electrical input for an electrical logic signal signal and includes control means responsive to the logic value of the electrical logic signal to set the magnitude of the current supplied to the laser to either one of two values in dependence upon the logic value of the electrical logic signal, at least one of the said two values being less than the laser threshold value of current for the laser in the absence of any light input signal.

The invention will be described in more detail, by way of example, with reference to the accompanying drawings, in which:

Figure 1A is a perspective view showing a first embodiment of this invention;

Figure 1B is a circuit diagram of a current drive circuit used in the first embodiment;

Figures 2A to 2D show characteristics of a semiconductor laser having a differential gain characteristic;

Figures 3A and 3B are truth tables illustrating logical product and sum operations respectively of the first embodiment of this invention;

Figures 4A to 4D show characteristics of a semiconductor laser having a bistable characteristic;

Figure 5 is a block diagram of a second embodiment of this invention;

Figures 6A and 6B show characteristics of a semiconductor laser used in the second embodiment of this invention; and

Figure 7 is a table for explaining bistable operation of the second embodiment.

### Description of the Preferred Embodiments

Figure 1A shows a first embodiment of this invention which comprises a semiconductor laser 104 inputted with optical input signals 106 and 107 and outputting an optical output signal 105, and a current drive circuit 102 which varies current i supplied to the semiconductor laser 104 via a signal line 103 in accordance with a signal on an input electric signal line 101.

As shown in Figure 1B, the current drive circuit 102 shown in Figure 1A comprises a transistor 201 with its base electrode connected to the signal line 101, a resistor 202 of a resistance value $R_1$, having one end connected to the emitter electrode of transistor 201, a resistor 203 connected between

the emitter and collector electrodes of the transistor 201 and having a resistance value of $R_2$, and a power supply terminal 204 supplied with a voltage of + $V_{EE}$ and connected to the other end of the resistor 202.

When a sufficiently large positive voltage is applied to the base electrode of the transistor 201 via signal line 101, the transistor 201 is turned off so that a current i which is $V_{EE}/(R_1 + R_2 + r_1)$ will flow to the semiconductor laser 104 connected to the collector electrode of the transistor 201, where $r_1$ represents the internal resistance of the semiconductor laser 104.

When the base potential of transistor 201 is zero, the transistor 201 is turned on to supply a current i which is $V_{EE}/(R_1 + r_1 + r_2)$ to the semiconductor laser 104, where $r_2$ represents the internal resistance of the transistor 201 and $R_2 \gg r_2$ stands. As described above, the circuit shown in Fig. 1B can supply a binary current to the semiconductor laser 104 in response to the voltage of an external signal. The levels of the binary current can be set to any values by suitably selecting resistance values of resistors 202 and 203.

The semiconductor laser 104 has a differential gain characteristic, and Fig. 2A shows the relation between the light quantity $P_{out}$ of the output optical signal 105 and the value of injection current i, and Figs. 2B to 2D show the relation, for different values of the parameter of injection current i, between the light quantity $P_{out}$ and the total quantity of input light $P_{in}$ which is the sum of the input light quantities, i.e. $P_{in} = P_{in1} + P_{in2}$, where $P_{in1}$ represents the light quantity of the input optical signal 106 and $P_{in2}$ represents the light quantity of the input optical signal 107.

The curve of Fig. 2A is plotted for $P_{in}$ = 0(zero $\mu$W). As shown by the differential gain characteristic of Fig. 2A, as the current i increases from 0-(zero)mA, there is a region in which the output light quantity $P_{out}$ increases abruptly from O$\mu$W to Ph = 2mW between $i_2$ = 25mA and $i_3$ = 30mA.

Fig. 2B shows the relation between the total quantity of input light $P_{in}$ and the quantity of output light $P_{out}$, when the value of the injection current i is set at $i_1$ = 2mA satisfying the relation $0 < i_1 < i_2$. In the differential gain characteristic of Fig. 2B, as $P_{in}$ increases from O$\mu$W, $P_{out}$ increases abruptly from O$\mu$W to Ph at a point where $P_{in} = P_2$ = 30$\mu$W.

Fig. 2C shows the relation between the total quantity of input light $P_{in}$ and the quantity of output light $P_{out}$ when the value of the injection current i is set to $i_2$, providing a differential gain characteristic in which, as $P_{in}$ increases from O$\mu$W, $P_{out}$ increases abruptly from 0 to Ph at $P_{in} = P_1$ = 10$\mu$W, where $P_1 < P_2$.

Fig. 2D shows the relation between the total quantity of the input light $P_{in}$ and the quantity of output $P_{out}$ when the value of the injection current i is set to $i_3$, indicating that $P_{out}$ is maintained at a substantially constant value of pH independently of the value of $P_{in}$.

To execute a logical product operation, i.e. a logical AND, the correspondence between the value and the logic level of each of $P_{in1}$, $P_{in2}$, i and $P_{out}$ is set as follows.

A light quantity $P_{inL}$ corresponding to a low level of each of $P_{in1}$ and $P_{in2}$ is set to satisfy a relation $P_{inL} < P_1/2$, a light quantity $P_{inH}$ indicative of a H(high) level of the respective $P_{in1}$ and $P_{in2}$ is set to satisfy relations $P_1/2 < P_{inH} < (P_1 - P_{inL})$ and $P_{inH} < P_2/2$, the value at a L(low) level of i is set to $i_1$, the value of i at a H(high) level is set to $i_2$, the light quantity at the L level of $P_{out}$ is set to zero, and that at the H level is set to Ph. When the logic levels are set as described above, $P_{out}$ assumes the H level only when all of $P_{in1}$, $P_{in2}$ and i are at the H level. The reason for this will now be explained.

If all of $P_{in1}$, $P_{in2}$ and i are at the H level, $i = i_2$, and the total quantity of the input light $P_{in} = P_{in1} + P_{in2}$ satisfies $P_1 < P_{in} < 2(P_1 - P_{inL})$ and $P_{in} < P_2$. Consequently, according to the relation between $P_{in}$ and Pout shown in Fig. 2C, $P_{out}$ becomes Ph, which is H level.

On the other hand, when either one of $P_{in1}$, $P_{in2}$ and i is at the L level, $P_{out}$ becomes zero, which is the L level. For example, when $P_{in1}$ is at the L level, $P_{in} < P_1$, and $P_{out}$ becomes the L level both when $i = i_1$ and when $i = i_2$. In the case where $P_{in2}$ is at the L level, $P_{out}$ also becomes the L level. When i is at the L level, that is, $i = i_1$, $P_{out}$ is still at the L level when both $P_{in1}$ and $P_{in2}$ are at the H level because $P_{in} < P_2$ stands.

Fig. 3A is a truth table showing the above logical relation, in which the character X represents an arbitrary level which may be either L or H level. This truth table shows that when at least one of $P_{in1}$, $P_{in2}$ and i is at the L level, $P_{out}$ is at the L level, and that only when all of $P_{in1}$, $P_{in2}$ and i are at the H levels, is $P_{out}$ at the H level. When expressed by Boolean algebra, this logic relation represents the logical product: $P_{out} = P_{in1}.P_{in2}.i$.

On the other hand, to execute a logical sum operation, i.e. a logical OR, the values of $P_{in1}$, $P_{in2}$, i and Pout are made to correspond to logic levels in the following manner.

The light quantity $P_{inL}$ at the L level of $P_{in1}$ and $P_{in2}$ is made to satisfy the relation $P_{inL} < P_1/2$, the light quantity $P_{inH}$ at the H level of $P_{in1}$ and $P_{in2}$ is made to satisfy the relation $P_1 < P_{inH}$, the value of i at the L level is set to $i_2$, the value of i at the H level is set to is, the light quantity of $P_{out}$ at the L level is set to O and that at the H level is set to Ph. When respective logic levels are set in this man-

ner, $P_{out}$ is at the H level when at least one of $P_{in1}$, $P_{in2}$ and i is at the H level. When all of $P_{in1}$, $P_{in2}$ and i are at the L levels, $i = i_2$ stands and the total quantity of input light satisfies an equation.

$$P_{in} = (P_{in1} + P_{in2}) < P_1$$

Consequently, from the relation between $P_{in}$ and $P_{out}$ shown in Fig. 2C, $P_{out}$ becomes O, that is, assumes the L level. When at least one of $P_{in1}$, $P_{in2}$ and i is at the H level, $P_{out}$ is at the H level.

For example, when $P_{in1}$ is at the H level, $P_1 < P_{in}$ stands and in either case of $i = i_2$ or $i = i_3$, $P_{out}$ is at the H level. In the same manner, with $P_{in2}$ being at the H level, $P_{out}$ is at the H level. When $i = i_3$ stands, that is, i is at the H level, $P_{out}$ is always at the H level independently of the levels of $P_{in1}$ and $P_{in2}$.

Fig. 3B is a truth table showing this logic relation, in which the character X represents an arbitrary level which may be H or L level. This truth table shows that only when all of $P_{in1}$,$P_{in2}$ and i are the L levels, is $P_{out}$ at the L level, and that when at least one of $P_{in1}$, $P_{in2}$ and i is at the H level, $P_{out}$ is at the H level. When expressed by Boolean algebra, this logical relation represents the logic sum:

$$P_{out} = P_{in1} + P_{in2} + i.$$

Similar logical operation can be accomplished by using a semiconductor laser of an optically bistable characteristic having the same construction as that of the semiconductor laser possessing the differential gain as described above. The differential gain and optical bistable characteristic of a semiconductor laser is described in detail in Proceedings of the Institution of Electrical Engineers, Vol. 119, Pt. I, No. 4, AUGUST 1981, pages 141-148, "Optical bistable-switching operation in semiconductor lasers with inhomogeneous excitation".

Fig. 4A shows for a semiconductor laser possessing an optically bistable characteristic, the relation between the output light quantity $P_{out}$ and the value of injection current i, and Figs. 4B to 4D show the relation, for different values of injection current i, between the light quantity $P_{out}$ and the total quantity of input light $P_{in}$.

The curve of Fig. 4A is plotted for $P_{in} = 0\mu W$, and shows that when i is increased from zero, $P_{out}$ increases abruptly from zero to Ph (= 2mW) at a current value between $i_{2'} = 25$ mA and $i_{3'} = 30$ mA. Thereafter, irrespective of the increase in i, $P_{out}$ is maintained substantially constant at the value Ph. When i is then decreased, $P_{out}$ decreases abruptly to zero at a current value smaller than the current value between $i_{2'}$ and $i_{3'}$ at which the $P_{out}$ increased abruptly, thus manifesting an optically bistable characteristic having a hysteresis loop.

Fig. 4B shows the relation between $P_{out}$ and $P_{in}$ when $i = i_{1'}$ where $0 < i_{1'} < i_{2'}$. As shown, when $P_{in}$ is increased from zero, $P_{out}$ increases abruptly from zero to Ph at $P_{in} = P_{2b} = 35\mu W$, and irrespective of further increase in $P_{in}$, $P_{out}$ is maintained substantially constant at the value Ph. Thereafter, when $P_{in}$ is decreased, an optical bistable characteristic is obtained in which $P_{out}$ decreases abruptly to zero from Ph at $P_{in} = P_{2a} = 30\mu W$.

Fig. 4C shows the relation between $P_{in}$ and $P_{out}$ when the injection current i is set to $i_{2'}$. As shown, when $P_{in}$ is increased from zero, $P_{out}$ increases abruptly to Ph from zero at $P_{in} = P_{1b} = 15\mu W$, and irrespective of further increase in $P_{in}$, $P_{out}$ is maintained substantially constant at the value Ph. Then, as $P_{in}$ is decreased, $P_{out}$ decreases abruptly to zero from Ph at $P_{in} = P_{1a} = 10\mu w$, thus manifesting an optical bistable characteristic.

Fig. 4D shows the relation between $P_{in}$ an $P_{out}$ when the injection current i is set to $i_{3'}$. As shown, irrespective of the value of $P_{in}$, $P_{out}$ is maintained substantially constant at the value Ph.

Correspondence between the values of $P_{in1}$, $P_{in2}$ and i of the semiconductor laser manifesting the optical bistable characteristic described above and the logic levels is set in the following manner, as in the previous case of the semiconductor laser having the differential gain characteristic. In the logical product operation, the light quantity $P_{inL}$ for $P_{in1}$ and $P_{in2}$ at the low level is set to satisfy a relation $P_{inL} < P_{1a}/2$, the light quantity $P_{inH}$ at the H level is set to satisfy relations $P_{1b}/2 < P_{inH} < (P_{1a} - P_{inL})$ and $P_{inH} < P_{2a}/2$, the value of i at the L level is set to $i_{1'}$, the value of i at the H level is set to $i_{2'}$, the light quantity of $P_{out}$ at the L level is set to zero, and the light quantity of $P_{out}$ at the H level is set to Ph.

To execute a logical sum operation, the light quantity $P_{inL}$ for the L level of $P_{in1}$ and $P_{in2}$ is set to satisfy a relation $P_{inL} < P_{1a}/2$, the light quantity $P_{inH}$ for the H level of $P_{in1}$ and $P_{in2}$ is set to satisfy a relation $P_{1b} < P_{inH}$, the value of i at the L level is set to $i_{2'}$, the value of i at the H level is set to $i_{3'}$, the light quantity of $P_{out}$ at the L level is set to zero, the light quantity of $P_{out}$ at the H level is set to Ph. By setting respective levels in this manner, a similar logical sum operation is thus possible with the use of the semiconductor laser having an optically bistable characteristic.

Fig. 5 shows a second embodiment of this invention which comprises an optical waveguide path 702 which receives an optical data input signal D at one end 701, an optical gate 703 having an input terminal at the other end of the optical waveguide path 702 and enabled and disabled by a gate input signal G on a signal line 708, an

optical waveguide path 704 with one end connected to the output terminal of the optical gate 703, a bistable semiconductor laser 705 connected to the other end of the optical waveguide path 704, an optical waveguide path 706 with one end connected to the output terminal of the bistable semiconductor laser 705 and the other end 707 emitting light, and a control circuit 709 for controlling the value of current i injected into the bistable semiconductor laser 705 via conductor 710 in accordance with a gate input signal G on the signal line 708.

Figs. 6A and 6B are graphs of characteristic curves useful for explaining the operation of the bistable semiconductor laser 705 shown in Fig. 5 and show relations between current i injected into the laser 705 via the conductor 710, the quantity of input light $P_{in}$ inputted through the optical waveguide path 704, and the quantity of output light $P_{out}$ outputted through the optical waveguide path 706.

Fig. 6A shows the relation between current i and $P_{out}$ when $P_{in}$ = O. As can be noted from Fig. 6A, the bistable semiconductor laser 705 manifests an hysteresis characteristic. When current i is increased from zero, $P_{out}$ increases abruptly from zero to Ph = 2mW at i = $i_{uo}$ = 40mA. Thereafter, during further increase in current i, $P_{out}$ is maintained substantially constant at the value Ph. When current i is then decreased, $P_{out}$ decreases abruptly to zero from Ph at $i_{do}$ = 20mA which is smaller than $i_{uo}$. If the current i is selected to be $i_b$ = 30mA defined by a relation $i_{do} < i_b < i_{uo}$, two stable operating states, E standing for $P_{out}$ = Ph and F standing for $P_{out}$ = 0, are obtained.

Fig. 6B shows the relation between $P_{in}$ and $P_{out}$ when the injection current i is set to $i_o$ = 15mA which is smaller than $i_{do}$. As shown, when $P_{in}$ is increased from zero, $P_{out}$ increases abruptly from zero to Ph at a point $P_{in}$ = $P_u$ = 40uW. Thereafter, even when $P_{in}$ is increased to $P_3$ = 60$\mu$W, Pout will be maintained at a constant operating point I where $P_{out}$ is approximately equal to Ph. The, when $P_{in}$ is decreased, $P_{out}$ decreases abruptly to zero from Ph at $P_d$ = 20$\mu$W which is smaller than $P_u$.

Fig. 7 is a table for explaining the operation of the embodiment shown in Fig. 5, the table showing relations among the injection current i, the quantity of input light $P_{in}$, the operating points of the bistable semiconductor laser 705 shown in Figs. 6A and 6B, and the quantity of the output light $P_{out}$.

Suppose now that gate signal G is not supplied to signal line 708 shown in Fig. 5. At this time, since the optical gate 703 is disabled, the input light quantity of the laser is zeroed irrespective of the optical data input signal D inputted to the optical gate 703. At the same time, control circuit 709 injects current $i_b$ into the bistable semiconductor laser 705 in the absence of the gate input signal G. Accordingly, the laser 705 operates at either one of the operating points E and F shown in Fig. 6A and the quantity of its output light $P_{out}$ is maintained at Ph or zero (storage state).

When a gate input signal G is applied, the control circuit 709 supplies an injection current $i_o$ to the semiconductor laser 705. At the same time, the optical gate 703 is enabled or opened. Under these conditions, when a light data input signal D of a light quantity $P_3$ is applied to the bistable semiconductor laser 705 through optical waveguide paths 702, 704 and optical gate 703, the laser 705 operates at the operating point I shown in fig. 6B so that the quantity of its light output $P_{out}$ becomes Ph (set state). Thereafter, when the supply of the gate input signal G is stopped, the quantity of light output $P_{out}$ from the laser is maintained at the reset state to provide the output light quantity Ph, because the bistable semiconductor laser 705 operates at the operating point E shown in Fig. 6A even though the injection current I becomes $i_b$ and the quantity of light input $P_{in}$ to the laser 705 becomes zero. On the other hand, if the light date input signal D is not supplied when the gate input signal G on line 708 is applied to establish i = $i_o$ and to open the optical gate 703, the input light quantity $P_{in}$ to the laser 705 becomes zero, so that the bistable semiconductor laser 705 operates at the operating point H shown in Fig. 6B and the output light quantity $P_{out}$ is zeroed (reset state). Thereafter, the laser 705 operates at the operating point F even under a condition of i = $i_b$ and $P_{in}$ = 0 due to stoppage of the supply of the gate input signal G, thereby ensuring the output light quantity $P_{out}$ from the laser 705 to be maintained at zero in the storage state.

The optical gate 703 (Fig. 5) which is operated by an electric signal, can be an electronic optical switch or the first embodiment of the invention shown in Fig. 1. Electronic optical switches are described in detail, for example, in the Institute of Electrical and Electronics Engineers, Journal of Quantum Electronics, Oct. 1982, "Integrated optical switch matrix for single-mode fiber networks".

## Claims

**1.** An opto-electric logic element comprising a semiconductor laser (104), means for supplying at least one light input signal to the laser (104), and a circuit (102) for supplying an injection current (i) to the laser (104), characterised in that the current supplying circuit has an electrical input (101) for an electrical logic signal and includes control means (201) responsive to the logic value of the electrical logic signal to set the magnitude of the current

(i) supplied to the laser (104) to either one of two values in dependence upon the logic value of the electrical logic signal, at least one of the said two current values ($i_1$, $i_2$ (Fig. 2A)) being less than the laser threshold value of current for the laser (104) in the absence of any light input signal.

**2.** An opto-electric logic element according to claim 1, characterised in that one ($i_3$) of the said two current values exceeds the said laser threshold value of current in the absence of any light input signal.

**3.** An opto-electric logic element according to claim 1, characterised in that both of said two current values ($i_1$, $i_2$) are less than the said laser threshold of current in the absence of any light input signal, and the said two current values ($i_1$, $i_2$) are different values such that the smaller current value ($i_1$, $i_{1'}$) is less than the laser threshold current for a predetermined total light input signal, and the larger current value ($i_2$, $i_{2'}$) is larger than the said laser threshold current for the said predetermined total light input signal.

**4.** An opto-electric logic element according to any preceding claim, characterised in that the laser (104) has a bistable characteristic.

**5.** An opto-electric logic element according to claim 1, characterised in that the laser (705) has a bistable characteristic, one of the said two current values ($i_o$ in Fig. 6A and Fig. 6B) is less than the bistable turn-off current value ($i_{do}$) in the absence of any light input signal, and the other of the said two current values ($i_b$) is less than the said laser threshold value of current ($i_{uo}$) for the laser (705) in the absence of any light input signal but is greater than the said turn-off current value ($i_{do}$).

**6.** An opto-electric logic element according to claim 5, characterised in that the means for supplying at least one light input signal comprises an input light path (702) to an optical gate (703) having its output coupled optically to the laser (705) and having an electrical control signal input connected to receive the said electrical logic signal, the optical gate (703) in operation being open to allow light to pass to the laser (705) whenever the logic value of the electrical logic signal determines the current value to be the smaller ($i_o$) of the said two values, and being closed to prevent light passing to the laser (705) whenever the logic value of the electrical logic signal determines the current value to be the larger ($i_b$) of the said two values.

**Revendications**

**1.** Elément logique opto-électrique conprenant un laser à semi-conducteur (104), un moyen pour délivrer au moins un signal d'entrée de lumière au laser (104) et un circuit (102) pour appliquer un courant d'injection (i) au laser (104), caractérisé en ce que le circuit d'application de courant comporte une entrée électrique (101) destinée à un signal logique électrique et comprend un moyen de commande (201) sensible à la valeur logique du signal logique électrique pour établir l'intensité du courant (i) appliquée au laser (104) à l'une ou l'autre de deux valeurs en fonction de la valeur logique du signal logique électrique, au moins l'une des deux valeurs de courant ($i_1$, $i_2$) (figure 2A) étant inférieure à la valeur de seuil de laser du courant destiné au laser (104) en l'absence de tout signal d'entrée de lumière quelconque.

**2.** Elément logique opto-électrique selon la revendication 1, caractérisé en ce que l'une ($i_3$) des deux valeurs de courant dépasse la valeur de seuil de laser de courant en l'absence de tout signal d'entrée de lumière quelconque.

**3.** Elément logique opto-électrique selon la revendication 1, caractérisé en ce que les deux valeurs de courant ($i_1$, $i_2$) sont inférieures au seuil de laser de courant en l'absence de tout signal d'entrée de lumière quelconque et en ce que les deux valeurs de courant ($i_1$, $i_2$) sont des valeurs différentes telles que la valeur de courant la plus faible ($i_1$, $i_{1'}$) est inférieure au courant de seuil de laser pour un signal d'entrée de lumière total prédéterminé et en ce que la valeur de courant plus grande ($i_2$, $i_{2'}$) est supérieure au courant de seuil de laser pour le signal d'entrée de lumière total prédéterminé.

**4.** Elément logique opto-électrique selon l'une quelconque des revendications précédentes, caractérisé en ce que le laser (104) présente une caractéristique bistable.

**5.** Elément logique opto-électrique selon la revendication 1, caractérisé en ce que le laser (105) présente une caractéristique bistable, l'une des deux valeurs de courant ($i_o$, aux figures 6A et 6B) est inférieure à la valeur de courant de blocage bistable ($i_{do}$) en l'absence de tout signal d'entrée de lumière quelconque et en ce que l'autre des deux valeurs de courant ($i_b$) est inférieure à la valeur de seuil de laser de

courant ($i_{uo}$) destinée au laser (705) en l'absence de tout signal d'entrée de lumière quelconque mais est supérieure à la valeur du courant de blocage ($i_{do}$).

**6.** Elément logique opto-électrique selon la revendication 5, caractérisé en ce que le moyen pour délivrer au moins un signal d'entrée de lumière comprend un trajet de lumière d'entrée (702) vers une porte optique (703) ayant sa sortie couplée optiquement au laser (705) et ayant une entrée de signal de commande électrique connectée pour recevoir le signal logique électrique, la porte optique (703) en fonctionnement étant ouverte pour permettre à la lumière de passer vers le laser (705) chaque fois que la valeur logique du signal logique électrique détermine la valeur de courant comme étant la plus faible ($i_o$) des deux valeurs et étant fermée pour empêcher la lumière de passer vers le laser (705) chaque fois que la valeur logique du signal logique électrique détermine la valeur de courant comme étant la plus grande ($i_b$) des deux valeurs.

**Patentansprüche**

**1.** Opto-elektrisches Logikelement mit einem Halbleiterlaser (104), einer Einrichtung zum Liefern mindestens eines Lichteingangssignals an den Laser (104) und eines Schaltkreises (102) zum Liefern eines Injektionsstroms (i) an den Laser (104), **dadurch gekennzeichnet**, daß der Stromlieferschaltkreis einen elektrischen Eingang (101) für ein elektrisches Logiksignal hat und eine Steuereinrichtung (201) aufweist, die auf den Logikwert des elektrischen Logiksignals anspricht, so daß die Größe des an den Laser (104) gelieferten Stroms (i) in Abhängigkeit von dem Logikwert des elektrischen Logiksignals auf einen von zwei Werten eingestellt wird, wobei mindestens einer der zwei Stromwerte ($i_1$, $i_2$ (in Fig. 2A)) kleiner als der Laser-Schwellwert des Stroms für den Laser (104) ist, wenn kein Lichteingangssignal vorhanden ist.

**2.** Opto-elektrisches Logikelement nach Anspruch 1, **dadurch gekennzeichnet**, daß einer ($i_3$) der zwei Stromwerte den Laserschwellwert des Stroms übersteigt, wenn kein Lichteingangssignal vorhanden ist.

**3.** Opto-elektrisches Logikelement nach Anspruch 1, **dadurch gekennzeichnet**, daß beide Stromwerte ($i_1$, $i_2$) kleiner als der Laserschwellwert des Stroms sind, wenn kein Lichteingangssignal vorhanden ist, und die zwei Stromwerte ($i_1$, $i_2$) verschiedene Werte sind, so daß der kleinere Stromwert ($i_1$, $i_{1'}$) für ein bestimmtes Gesamtlichteingangssignal kleiner als der Laserschwellwertstrom ist, und der größere Stromwert ($i_2$, $i_{2'}$) für das genannte gesamte Lichteingangssignal größer als der Laserschwellwertstrom ist.

**4.** Opto-elektrisches Logikelement nach einem der vorstehenden Ansprüche, **dadurch gekennzeichnet**, daß der Laser (104) eine bistabile Charakteristik hat.

**5.** Opto-elektrisches Logikelement nach Anspruch 1, **dadurch gekennzeichnet**, daß der Laser (705) eine bistabile Charakteristik hat, wobei einer der zwei Stromwerte ($i_o$ in Figuren 6A und 6B) kleiner als der bistabile Abschaltstromwert ($i_{d0}$) ist, wenn kein Lichteingangssignal vorhanden ist, und der andere der zwei Stromwerte ($i_b$) kleiner als der Laserschwellwert des Stroms ($i_{u0}$) für den Laser (705) ist, wenn kein Lichteingangssignal vorhanden ist, aber größer als der Abschaltstromwert ($i_{d0}$) ist.

**6.** Opto-elektrisches Logikelement nach Anspruch 5, **dadurch gekennzeichnet**, daß die Einrichtung zum Liefern von mindestens einem Lichteingangssignal einen Eingangslichtweg (702) zu einem optischen Tor (703) hat, dessen Ausgang optisch mit dem Laser (705) verbunden ist, und einen elektrischen Steuersignaleingang hat, der zum Empfangen des genannten elektrischen Logiksignals verbunden ist, wobei das optische Tor (703) im Betrieb offen ist, so daß Licht durch den Laser (705) passieren kann, solange der Logikwert des elektrischen Logiksignals bestimmt, daß der Stromwert der kleinere ($i_0$) der zwei Werte ist, und geschlossen ist, so daß kein Licht durch den Laser (705) passieren kann, solange der Logikwert des elektrischen Logiksignals bestimmt, daß der Stromwert der größere ($i_b$) der zwei Werte ist.

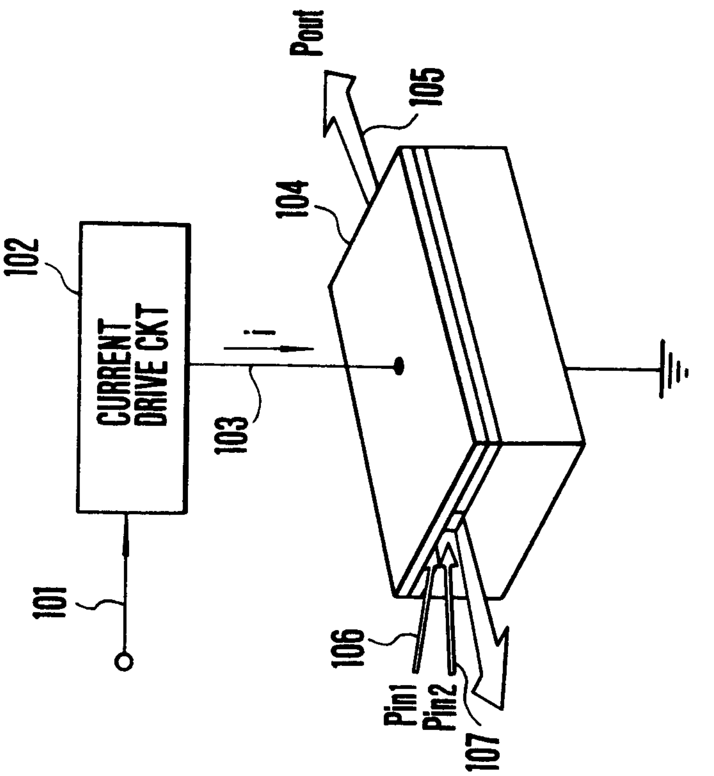
101
102
CURRENT DRIVE CKT
103
i
104
105
Pout
106
Pin1
Pin2
107

FIG.1A

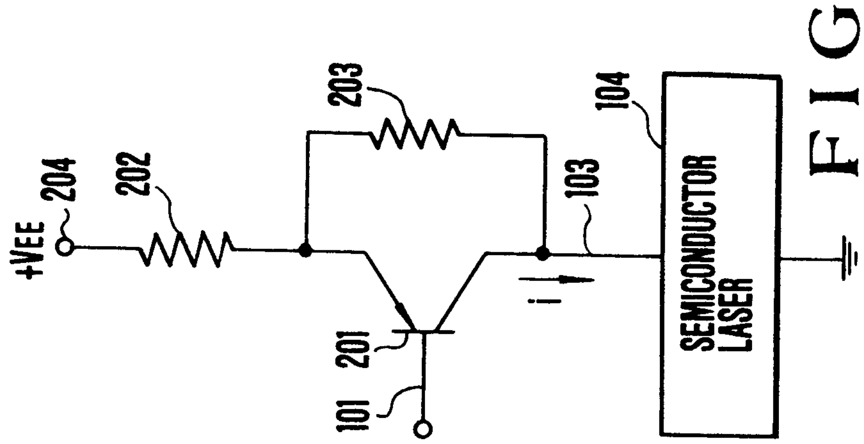
+VEE
204
202
203
201
101
103
i
104
SEMICONDUCTOR LASER

FIG.1B

FIG.2A

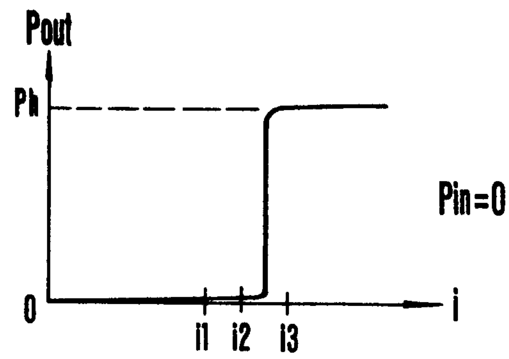


FIG.2B

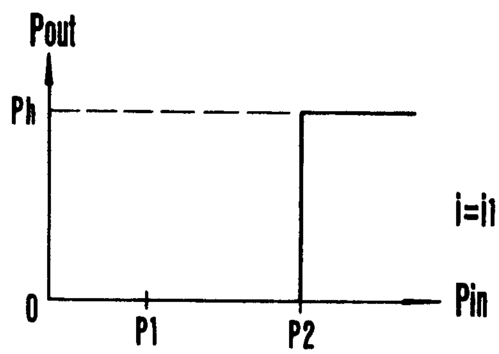


FIG.2C

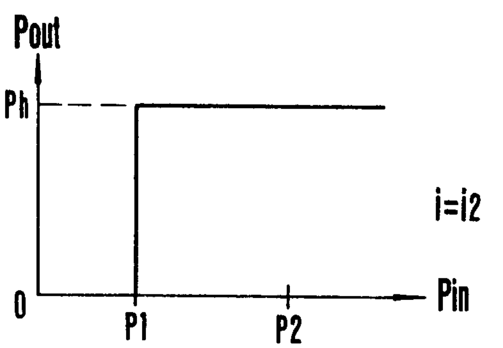


FIG.2D

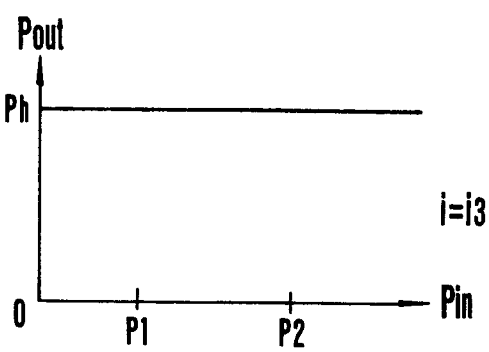

| Pin1 | Pin2 | i | Pout |
|---|---|---|---|
| L | X | X | L |
| X | L | X | L |
| X | X | L | L |
| H | H | H | H |

F I G.3A

| P1 | P2 | i | Pout |
|---|---|---|---|
| L | L | L | L |
| H | X | X | H |
| X | H | X | H |
| X | X | H | H |

F I G.3B

F I G.4A

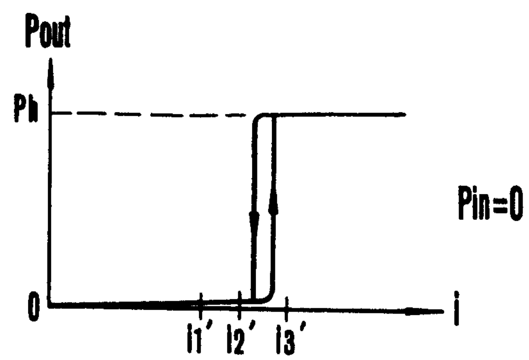


F I G.4B

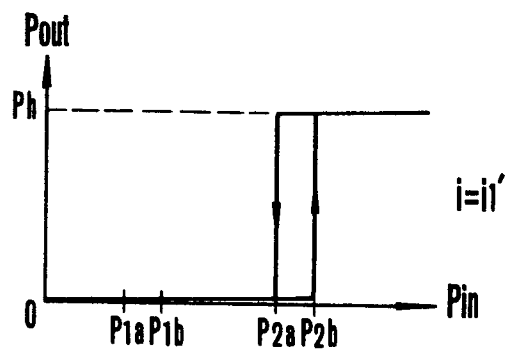


F I G.4C

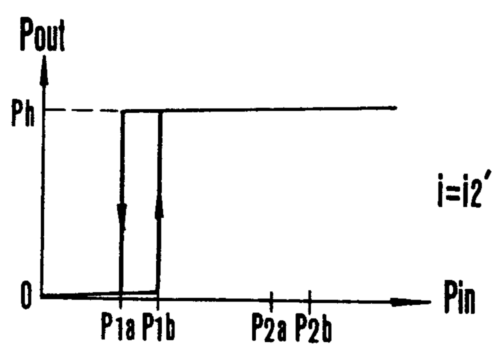


F I G.4D

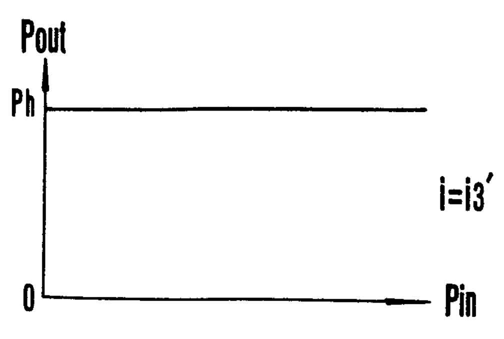

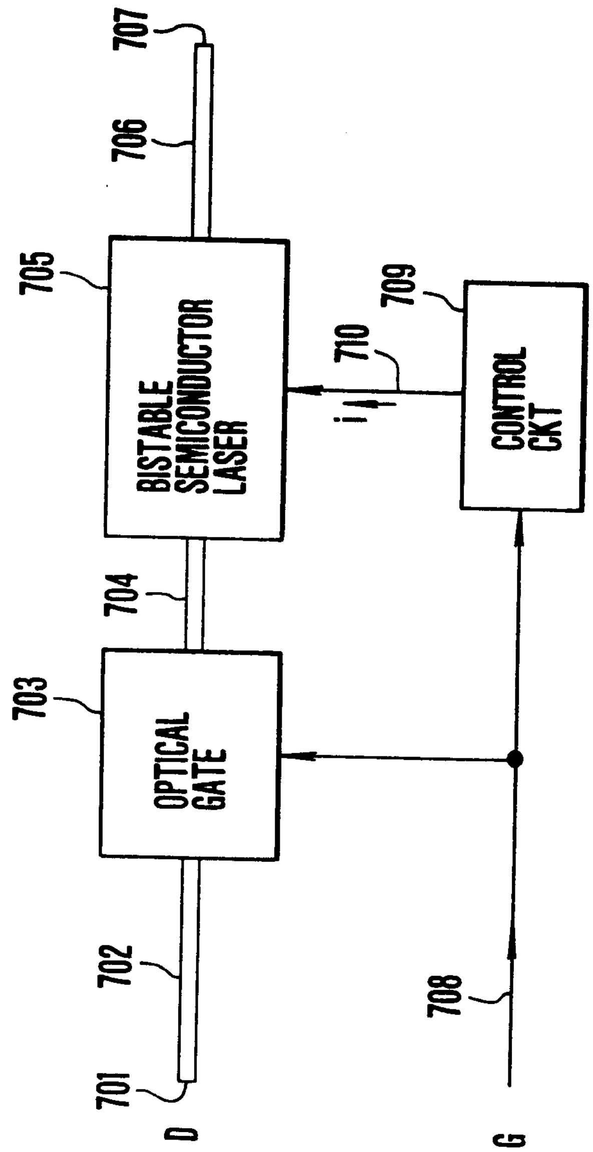
D
701
702
OPTICAL GATE
703
704
BISTABLE SEMICONDUCTOR LASER
705
706
707
G
708
CONTROL CKT
709
710
i

FIG.5

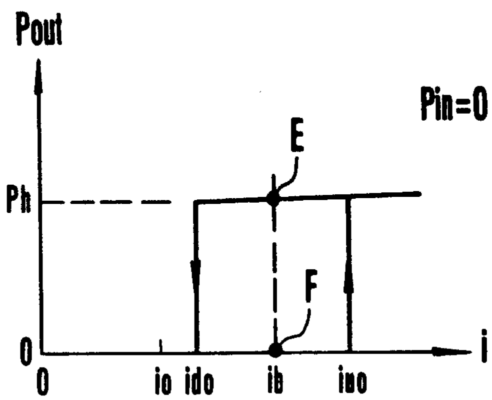


F I G.6A

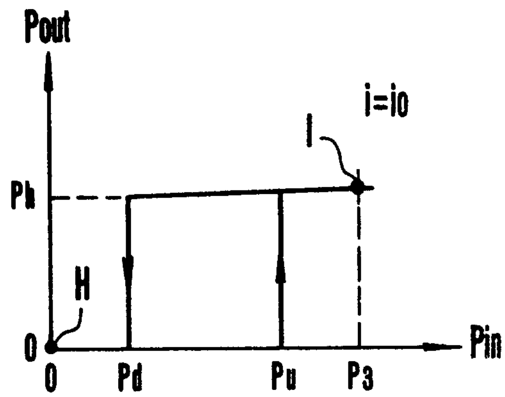


F I G.6B

| | i | Pin | OPERATING POINT IN FIGS. 6A AND 6B | Pout |
|---|---|---|---|---|
| STORAGE STATE | ib | 0 | E OR F | Ph OR 0 |
| SET OPERATION | io | P3 | I | Ph |
| RESET OPERATION | | 0 | H | 0 |

F I G.7